# EUROPEAN PATENT APPLICATION

(11) **EP 2 916 385 A1**
(43) Date of publication of application: **09.09.2015**
(21) Application number: 14290056.2
(22) Date of filing: 07.03.2014
(51) Int. Cl.: H01Q 1/12, H01L 41/00, H01Q 3/02, H01Q 3/32

(54) **Antenna and method of operating an antenna**

(71) Applicant: ALCATEL LUCENT, 92100 Boulogne-Billancourt (FR)
(72) Inventor: Templ, Wolfgang, Dr., 70435 Stuttgart (DE); Wiegner, Dirk, 70435 Stuttgart (DE); Pescht, Andreas, Dr., 70435 Stuttgart (DE)
(74) Representative: DREISS Patentanwälte PartG mbB

(57) **Abstract**

The invention relates to an antenna (100) comprising at least one antenna element (110) for transmitting and/or receiving radio frequency, RF, signals, wherein said antenna (100) comprises at least one electromechanic actuator (120) for moving said at least one antenna element (110) with respect to a further component of said antenna (100).

## Description

### Field of the invention

The invention relates to an antenna comprising at least one antenna element for transmitting and/or receiving radio frequency, RF, signals. The invention further relates to a method of operating an antenna.

### Background

Conventional antennas with a configurable antenna characteristic, i.e. beam pattern, usually require electronic phase shifting means which provide phase-shifted copies of e.g. a transmission signal or different transmission signals to different antenna elements in order to control the antenna characteristic for transmission of said transmission signal. The degree of variation of the beam pattern and the energy efficiency are limited by the available phase shifting devices due to a limited maximum achievable phase shift of the devices and insertion/transmission losses. Also, since the phase shifting devices and their signal paths constitute further RF signal paths as opposed to a single RF transmission signal, the further known problems related thereto (undesired different electrical lengths / length variations due to external influences such as e.g. temperature, RF leakage / interference) increase proportionally with the required number of phase shifters.

### Summary

In view of this, it is an object of the present invention to provide an improved antenna and an improved method of operating an antenna which avoid the disadvantages of the prior art.
Regarding the antenna of the above-mentioned type this object is achieved by said antenna comprising at least one electromechanic actuator for moving said at least one antenna element with respect to a further component of said Antenna. Electromechanic actuators enable to avoid e.g. electronic phase shifters and the associated disadvantages while requiring a comparatively low amount of electric control power.
According to an embodiment, at least one electromechanic actuator may be provided to adjust a position of at least one antenna element of the antenna in a predetermined, for example a normal, direction to a reference plane of the antenna. For example, when providing an array antenna according to an embodiment, at least one electromechanic actuator may be provided to adjust a position of at least one antenna element of the antenna in a normal direction with respect to a backplane of said array antenna. According to further embodiments, adjustments along one or more other directions (e.g., parallel to a reference plane, or at arbitrary angles) are also possible.
According to an embodiment, at least one electromechanic actuator may be configured such that it alters at least one of its geometric dimensions in response to a change in an electric control voltage, which may be applied to the electromechanic actuator by means of electrodes. For example, a direct current (DC) voltage with several voltage levels may be used as a control signal for an electromechanic actuator according to an embodiment. However, according to further embodiments, AC voltages or combinations of DC and AC voltages (e.g., over time), may also be used.
According to an embodiment, the electromechanic actuator(s) may be made of smart materials which can change at least one of their dimensions (e.g., "grow" or "shrink") when stimulated e.g. electrically, for example by a DC voltage. According to a further embodiment, one or more antenna elements of an antenna may be placed on small posts made of or comprising at least one electromechanic actuator, whereby an efficient mechanical shift of said one or more antenna elements may be attained with respect to each other and/or a component of said antenna thus effecting a control of a beam pattern of said antenna while not requiring any RF signal phase shifting. Advantageously, the amount of energy involved by the control mechanism according to the embodiments is very small. Further advantageously, according to an embodiment, control circuitry for generating a control voltage for the electromechanic actuator(s) is usually not required to comprise RF components. Rather, an AC voltage up to e.g. some kHz (Kilohertz) or some tens or at best hundreds of kHz will be sufficient (if supported by the specific material).
According to an embodiment, said at least one electromechanic actuator is configured to move said at least one antenna element with respect to at least one further antenna element of said antenna, whereby a relative phase shift of RF signals associated with said antenna elements may efficiently be obtained.
According to a further embodiment, said at least one electromechanic actuator comprises an electroactive Polymer material (EAP). For example, EAP materials can advantageously change their dimensions ("grow" or "shrink") when stimulated by an electric voltage, e.g. a DC (direct current) voltage, or an AC voltage. Further advantageously, the amount of electrical energy required for a corresponding control mechanism is very small. According to an embodiment, said EAP material may comprise at least one of: Ionic Polymer Metal Composites (IPMCs), Polyacrylamide and Polyacrylic acid cross- linked gels, Carbon Nanotube based EAPs, VHB (a network of polymers; provided commercially as a tape from 3M Company), VHB Trimethylolpropane trimethacrylate interpenetration networks (TMPPMA).

According to a further embodiment, alternatively or additionally to EAP materials, piezoelectric actuators may also be used.
According to a further embodiment, said at least one electromechanic actuator is arranged on a carrier element of said Antenna, wherein preferably a first surface of said electromechanic actuator is arranged on a surface of said carrier element, whereby an efficient mounting of the actuator is enabled and no separate mounting elements are required.
According to a further embodiment, at least one antenna element is arranged on a second surface of said at least one electromechanic actuator, wherein said second surface is preferably arranged opposite to said first surface of said at least one electromechanic actuator, whereby a particularly small setup is enabled. According to an embodiment, the electromechanic actuator may be shaped such that its first and second surfaces are substantially parallel to each other. However, alternatively, the electromechanic actuator may be shaped such that its first and second surfaces are not parallel to each other, whereby further degrees of freedom regarding a desired antenna beam pattern may be attained. According to other embodiments, various electromechanic actuators with different geometry each may be provided.
According to a further embodiment, an electrically isolating element, preferably an electrically isolating layer, is interposed between said at least one antenna element and said at least one electromechanic actuator, which e.g. ensures that an electric control voltage for said actuator does not interfere with electric signal paths or reference planes of said antenna element.
According to a further embodiment, at least one antenna element comprises a flexible waveguide connected to said antenna element, whereby flexible relative movement of the antenna element driven by an actuator and RF signal supply to/from the antenna element is ensured.
According to a further embodiment, said at least one electromechanic actuator comprises a basically cylindrical geometry, particularly with a rectangular cross-section, so that especially planar-shaped antenna elements may directly be attached to said actuator.
According to a further embodiment, said at least one electromechanic actuator is arranged on a surface of a carrier element of said Antenna such that a longitudinal axis of said at least one electromechanic actuator extends substantially parallel to said surface of said carrier element. This configuration enables to e.g. provide linear arrays of several antenna elements arranged on a same electromechanic actor. In other words, according to a further embodiment, a plurality of antenna elements is arranged along said longitudinal axis of said at least one electromechanic actuator.
According to a further embodiment, two or more electromechanic actuators are provided, which increases the number of degrees of freedom regarding relative phase control between RF signals of different antenna elements associated with / driven by the respective actuators. According to a further embodiment, at least one antenna element, preferably more than two antenna elements, are provided on each electromechanic actuator.
According to a further embodiment, at least two electromechanic actuators comprise different geometry and/or size.
A further solution to the object of the present invention is provided by a method of operating an antenna comprising at least one antenna element for transmitting and/or receiving radio frequency, RF, signals, wherein said antenna comprises at least one electromechanic actuator, and wherein said at least one antenna element is moved with respect to a further component of said antenna by means of said at least one electromechanic actuator.
According to an embodiment, a relative phase between RF signals transmitted from and/or received from two different antenna elements is controlled by moving at least one of said two different antenna elements by means of said at least one electromechanic actuator.

### Brief description of the figures

Further features, aspects and advantages of the present invention are given in the following detailed description with reference to the drawings in which:
- Figure 1: Schematically depicts a side view of an antenna according to an embodiment,
- Figure 2a, 2b: schematically depict side views of antennas according to further embodiments,
- Figure 3: schematically depicts a side view of a single antenna element arranged on a surface of an electromechanic actuator according to an embodiment,
- Figure 4: schematically depicts a side view of an antenna according to a further embodiment,
- Figure 5, 6a 6b: schematically depict further embodiments of an antenna, and
- Figure 7: schematically depicts a flow-chart of a method according to an embodiment.

### Description of the embodiments

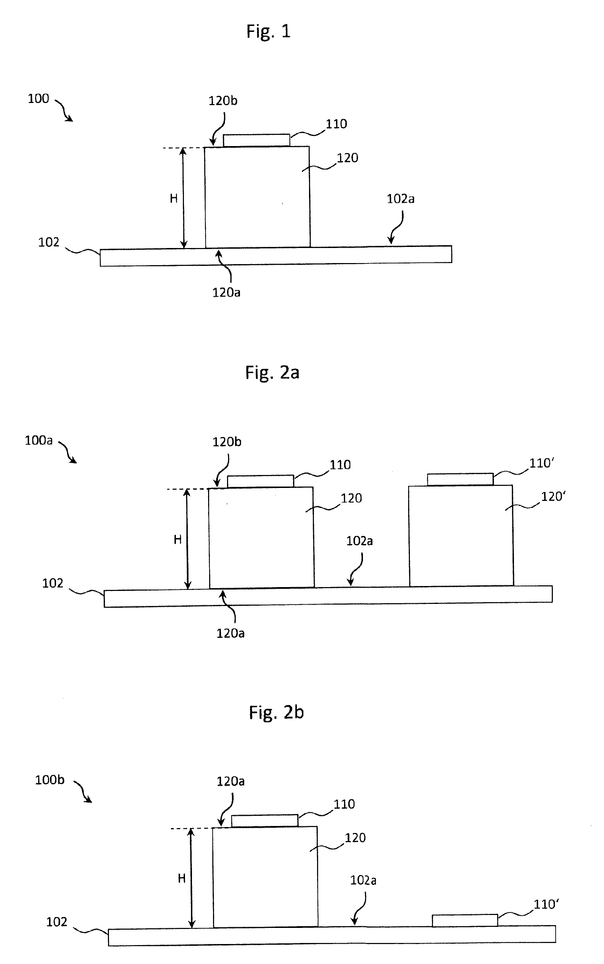

Figure 1 schematically depicts a side view of an antenna 100 according to a first embodiment. The antenna 100 comprises a carrier element 102. A first antenna element 110 is provided which is used for transmitting and/or receiving radio frequency signals in a per se known manner. According to the present embodiment, an electromechanic actuator 120 is provided such that a first surface 120a of said electromechanic actuator 120 is arranged on a surface 102a of said carrier element 102. The antenna element 110 is arranged on a second surface 120b of the electromechanic actuator 120. Note that the various elements are not necessarily drawn to scale for reasons of clarity.

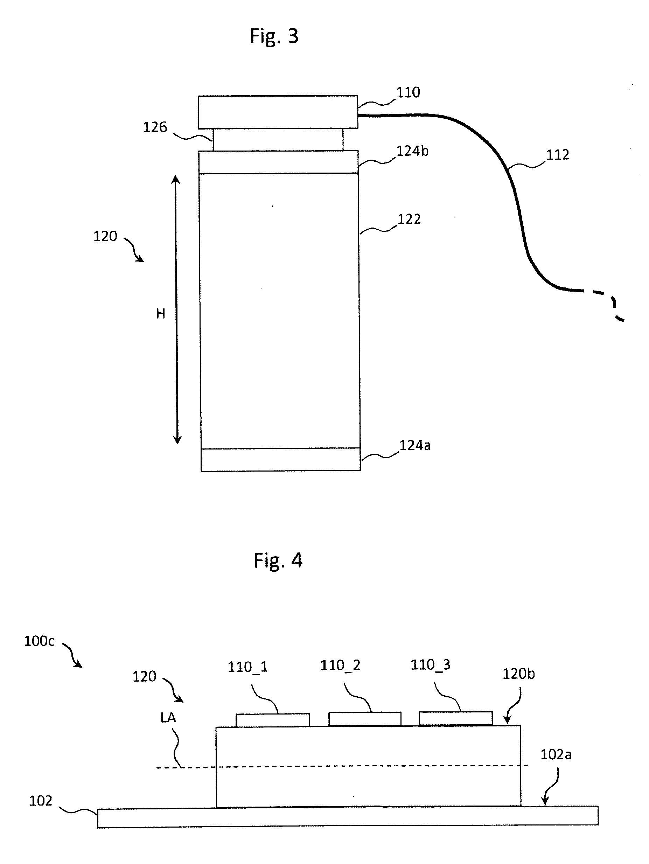

Advantageously, the electromechanic actuator can alter its geometry, presently for example its height H as indicated by the double arrow of figure 1. Thus, a vertical distance between the antenna element 110 and the surface 102a of the carrier element 102 of the antenna 100 may be altered by applying a corresponding control voltage to the electromechanic actuator 120. Exemplary details regarding the application of the control voltage to the electromechanic actuator are given below with reference to figure 3.

By altering the geometry of the electromechanic actuator 120 and thus moving the antenna element 110 with respect to the carrier element 102, a phase relationship of RF signals transmitted by the antenna element 110 with respect to other RF signals emitted e.g. by further antenna elements (not shown) of the antenna 100, which may e.g. directly attached to the surface 102a of the carrier element 102, may be altered, whereby an antenna characteristic of the resulting RF beam pattern may advantageously be controlled.

Figure 2a schematically depicts a side view of an antenna 100a according to a further embodiment. In addition to the first antenna element 110 and its electromechanic actuator 120, a further antenna element 110' is provided, which comprises an associated electromechanic actuator 120'. Thus, by controlling the respective actuators 120, 120', the antenna elements 110, 110' may individually be controlled regarding their relative position to each other or with respect to the surface 102a of the carrier element 102, respectively.

Figure 2b depicts a further configuration 100b according to an embodiment, wherein the further antenna element 110' of the antenna 100b is directly arranged on the top surface 102a of the carrier element 102.

Figure 3 schematically depicts a side view of an antenna element 110 according to a further embodiment. Presently, the electromechanic actuator 120 comprises an electroactive polymer material (EPA), which comprises a basically cylindrical geometry with basically rectangular cross-section. The EPA material, which according to the present embodiment forms a main body of the actuator 120, is denoted with reference sign 122. Electrically conductive electrodes 124a, 124b are provided, preferably in layer form, on opposing front surfaces of EPA material body 122, preferably along a desired direction of extension and compression, and an electric control voltage (not shown) can thereby be applied to the electromechanic actuator 120 in order to alter its height H, whereby a relative displacement of antenna element 110 with respect to other components of an antenna (not shown) comprising the antenna element 110 may be effected. In order to reliably provide the antenna element 110 with an RF signal independent of a specific position of the antenna element 110 with respect to the carrier element 102, a flexible RF-capable waveguide 112 such as a coaxial cable or the like is provided. According to an embodiment, the antenna element 110 may both be used for transmitting and/or receiving RF signals.

According to a further embodiment, optionally, an insulating layer 126 may be provided between the top electrode 124b of the electromechanic actuator 120 and the antenna element 110 to provide an increased electrical separation (e.g., galvanic isolation) of these neighbouring components 124b, 110.

According to a further embodiment, the antenna element 110 may e.g. comprise an electrically conductive material layer, such as e.g. a metallized layer, to form a radiating element, as per se known in the art.

One or more of the antenna elements 110 as depicted by Figure 3 together with corresponding electromechanic actuators 120 may e.g. be arranged on a common carrier 102 as e.g. depicted by figure 1, whereby a sophisticated array antenna may be provided with superior beam control capabilities. For altering a beam pattern of such antenna, one or more of said electromechanic actuators 120 may be controlled to effect a relative displacement between antenna elements 110 of the antenna. The control of said electromechanic actuators 120 may e.g. be performed by a transceiver unit (not shown) which also processes RF signal transmissions to/from said antenna. Alternatively or in addition, a separate control unit (not shown) for controlling said electromechanic actuators 120 may be provided.

According to a further embodiment, a plurality of antenna elements as e.g. depicted by Figure 3 may preferably be arranged in a matrix form, e.g. comprising rows and columns of individual antenna elements. Also, according to a further embodiment, only one of a plurality of antenna elements may comprise an associated electromechanic actuator 120. However, it is also possible according to a further embodiment to provide some or all individual antenna elements with an own electromechanic actuator 120.

Figure 4 schematically depicts a side view of an antenna 100c according to a further embodiment. In this configuration, an electromechanic actuator 120, preferably again comprising or consisting of electroactive polymer material (EAP), comprises a basically cylindrical shape with a basically rectangular cross-section, wherein the electromechanic actuator 120 is arranged on the carrier element 102 such that its longitudinal axis LA is arranged substantially parallel to the surface 102a of the carrier element 102. By applying a corresponding control voltage to the electromechanic actuator 120, its vertical (Fig. 4) dimension may be altered such that a relative distance between the individual antenna elements 110_1, 110_2, 110_3 and the surface 102a of the carrier element 102 of the antenna 110 may be altered.

Although Figure 4 exemplarily depicts three antenna elements 110_1, 110_2, 110_3 arranged on the surface 120b of the electromechanic actuator 120, according to further embodiments, other numbers of antenna elements may be arranged on a same electromechanic actuator 120.

According to a further embodiment, it is also possible to provide at least one of said three antenna elements 110_1, 110_2, 110_3 arranged on the surface 120b of the electromechanic actuator 120 with a further, preferably individual, electromechanic actuator (not shown) which would even further increase a flexibility regarding shaping a beam pattern of the antenna 100c.

According to further embodiments, it is also possible to arrange a plurality of antenna elements in matrix form, i.e. having one or more rows and one or more columns, on a same electromechanic actuator 120.

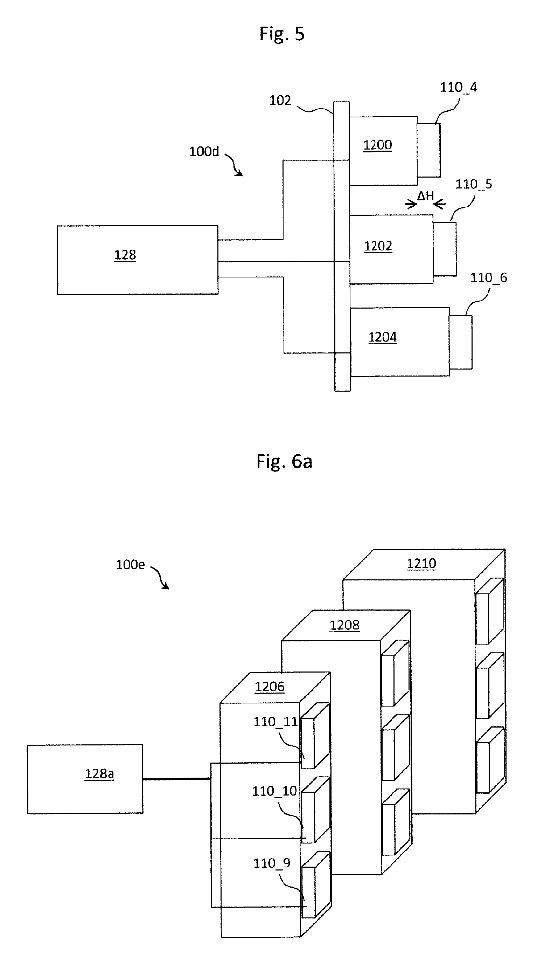

Figure 5 schematically depicts a side view of an antenna 100d_according to a further embodiment. Three electromechanic actuators 1200, 1202, 1204, each preferably of the EAP type, are arranged on a common carrier element 102 of the antenna 100d. In contrast to the embodiment according to Fig. 2a, which depicts two electromechanic actuators 120, 120' of about the same basic geometry and size, the electromechanic actuators 1200, 1202, 1204 of Figure 5 comprise different heights (extending horizontally in Fig. 5) such that the antenna elements 110_4, 110_5, 110_6 in the absence of any control voltage to the electromechanic actuators 1200, 1202, 1204 are arranged with different distances to the carrier element 102.

According to a further embodiment, all three electromechanic actuators 1200, 1202, 1204 may also comprise the same basic size, and Fig. 5 may be interpreted to depict an operational state in which different control voltages are applied to the electromechanic actuators 1200, 1202, 1204 effecting the different heights.

According to a further embodiment, a control unit 128 may be provided which is configured to apply an individual control voltage to each of said electromechanic actuators 1200, 1202, 1204. According to a further embodiment, the functionality of the control unit 128 may also be integrated into a transceiver system (not shown) providing RF signals to said antenna 100d and/or receiving RF signals from said antenna 100d.

Figure 6a schematically depicts a perspective view of an antenna 100e according to a further embodiment. Three electromechanic actuators 1206, 1208, 1210 are provided which may be arranged on a common carrier element (cf. reference numeral 102 of Fig. 1), which is not depicted in Fig. 6a for the sake of clarity. Each of said electromechanic actuators 1206, 1208, 1210 comprises three antenna elements arranged on a surface, wherein only the three antenna elements 110_9, 110_10, 110_11 are provided with reference signs. Thus, all three antenna elements 110_9, 110_10, 110_11 of electromechanic actuator 1206 may simultaneously be moved by controlling said electromechanic actuator 1206, i.e. by applying a corresponding control voltage. The position of the antenna elements of the further electromechanic actuators 1208, 1210 may be controlled likewise. In other words, the antenna 100e of Figure 6a comprises three columns of three antenna elements each, wherein each column may individually be controlled regarding its distance to the carrier element 102 (Fig. 1) or with respect to the other columns, respectively, by applying a corresponding control voltage to the respective electromechanic actuator 1206, 1208, 1210.

Item 128a of Fig. 6a represents a transceiver unit which provides each of the nine antenna elements of the antenna 100e with the same RF signal (and/or which receives RF signals received by said antenna elements). Note that only three RF waveguides are schematically indicated for the three antenna elements 110_9, 110_10, 110_11, but that the further antenna elements of the other actuators 1208, 1210 may be connected to the unit 128a likewise.

Optionally, the transceiver unit 128a may also include actuator controller capability to provide a control voltage to each of the electromechanic actuators 1206, 1208, 1210 thus altering a resulting antenna characteristic of the antenna 100e. Note that control lines from the controller capability to the electromechanic actuators 1206, 1208, 1210 are not shown in Fig. 6a for the sake of clarity.

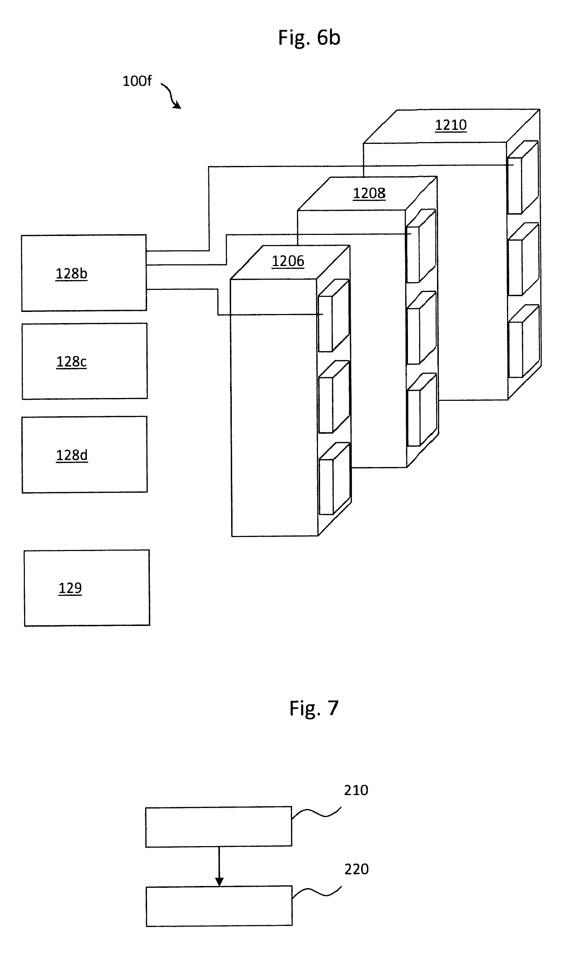

Figure 6b schematically depicts a perspective view of an antenna 100f according to a further embodiment. The number of electromechanic actuators 1206, 1208, 1210 and antenna elements arranged thereon is identical to the embodiment according to Figure 6a. However, a first transceiver unit 128b is provided for supplying all antenna elements of a same row with the same RF signal. Presently, this is illustrated by schematic RF signal lines extending between the first transceiver unit 128b and all antenna elements of a first, in Fig. 6b vertically upper, row. Likewise, the three antenna elements of a second row of antenna 100f are commonly controlled by a second transceiver unit 128c, and the three antenna elements of a third row of antenna 100f are commonly controlled by a third transceiver unit 128d.

Exemplarily, the control functionality for controlling the electromechanic actuators 1206, 1208, 1210 is depicted by function block 129 in Figure 6b. However, this functionality 129 may also be included in one or more of said transceiver units 128b, 128c, 128d.

According to a further embodiment, a control functionality for the electromechanic actuators 1206, 1208, 1210 and/or a transceiver unit may also comprise a lookup table which associates control voltages for the electromechanic actuators 1206, 1208, 1210 with related phase delays and/or related resulting beam patterns and/or digitally controlled processing delays of RF signals to/from the antenna elements as processed within said transceiver unit(s).
Thus, a desired beam pattern may efficiently be attained by applying the corresponding control voltage(s) from the lookup table depending on said desired beam pattern and/or further related parameters. Such a lookup table may be determined during manufacturing of the antenna or within a test environment by measurement of the control voltages and resulting beam patterns, and/or by simulation.

Figure 7 schematically depicts a flow-chart of a method according to an embodiment. In step 210, control unit 129 (Fig. 6b) sets a desired beam pattern for the antenna 100f by applying respective control voltages to the individual electromechanic actuators 1206, 1208, 1210. After that, in step 220, an RF signal is transmitted and/or received by the antenna 100f using said desired beam pattern.

Although the above explained embodiments are directed to examples in which EAP actuators are used, the principle according to the embodiments may also be implemented by using piezoelectric actuators.

The principle according to the embodiments advantageously enables to achieve a substantially higher phase shift effect and thus flexibility regarding the possible beam patterns / tilt angles of a main lobe along with a higher energy efficiency of the system, as compared to conventional phased array antennas.

According to an embodiment, smart materials like e.g. electroactive (EA) polymers exhibit mechanical strain and change their dimension when an electrical field is applied. This change is substantial and can exceed 30%.

According to an embodiment, one or more elements of an active antenna array are individually placed on posts made of EA polymers.

According to an embodiment, a difference ΔH in height between electromechanic actuators 1200, 1202 carrying different antenna elements 110_4, 110_5 (Fig. 5) defines a phase offset between RF signals transmitted or received thereby. Generally, a signal phase offset ϕ between the individual antenna elements 110_4, 110_5 is generated by the relative vertical position offset ΔH which again is a function F of the control voltage Vc applied to the control electrodes 124a, 124b (Fig. 3) of the respective actuator 1200, 1202.

According to an embodiment, e.g. the component of the electrical field E along z-direction (positive vertical direction in Figure 1) reads (t=time, k=wave vector, ω=frequency):
E(z,ω) = exp[i(ωt-k(z-ΔH))] = exp[i(ωt-kz-ϕ))], with phase offset ϕ=k·ΔH= k·F(Vc),
Wherein exp(.) is the exponential function, wherein i is the imaginary unit.

It is emphasized that when using EAP material or piezoelectric material, basically only the tuning procedure, i.e. change of control voltage, involves a certain small energy loss (required for charging parasitic capacities of the actuators). As soon as the material 122 (Fig. 3) has reached the required mechanical dimension there will be no flow of control current anymore and even though, for some types of EAP material,the control voltage needs to remain applied this involves no loss of energy because (control) current is nearly zero. According to further embodiments, for some other types of EAP materials, particularly for dielectric EAP materials such as electrostrictive polymers and dielectric elastomers, it is not even required to permanently apply a control voltage. Rather, these devices may be charged to a desired voltage, which corresponds to a desired change of geometry, and after that, a control circuit may be deactivated or disconnected from the actuator.

According to an embodiment, if all antenna elements are equipped with an own actuator, e.g. a single transceiver may be used for controlling all antenna elements.

Several further variations/embodiments are exemplarily possible:

In a further embodiment, cf. e.g. Fig. 6a, all antenna elements in a column are commonly phase controlled by a common EAP type actuator and may be controlled (regarding RF signal) by a single transceiver, enabling beam control e.g. preferably in horizontal direction.

In a further embodiment, all antenna elements in a row of e.g. Fig. 6b may commonly be controlled by a single transceiver, additionally enabling also vertical beam control.

According to a further embodiment, a first group of antenna elements, at least some of which are controllable regarding their position by means of first electromechanic actuators, may be used for RF signal transmission, and a second group of antenna elements, at least some of which are controllable regarding their position by means of said first and/or second electromechanic actuators, may be used for RF signal reception.

According to a further embodiment, in order to later adjust correct beam forms of an antenna, the antenna is firstly measured/calibrated, e.g. by sweeping the different phase delays in a measurement environment. The different control voltages for the electromechanic actuators and their related phase delays and resulting beam forms may be stored in one or more look-up tables, allowing applying appropriate control voltages, later in the field, e.g. for different RF signal coverage scenarios.

The principle according to the embodiments allows for realisation of e.g. a phased antenna array with superior performance concerning energy efficiency and maximum achievable tilt angle. In static operation (no tuning ongoing) the setup may behave as a purely passive component and needs nearly no energy to maintain the currently set beam characteristic. This solution saves operation costs, allows for smarter design, and allows for a number of additional phased array applications - avoiding electronic phase shifters and complex mechanical drives. It is more robust and can be realised at reduced costs.

The principle according to the embodiments also features a low complexity. It further features a higher energy efficiency and an increased maximum tilt angle.

The solution is superior in performance, bill of material and operation costs.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Antenna (100) comprising at least one antenna element (110) for transmitting and/or receiving radio frequency, RF, signals, wherein said antenna (100) comprises at least one electromechanic actuator (120) for moving said at least one antenna element (110) with respect to a further component (102, 110') of said Antenna (100).

2. Antenna (100) according to claim 1, wherein said at least one electromechanic actuator (120) is configured to move said at least one antenna element (110) with respect to at least one further antenna element (110') of said Antenna (100).

3. Antenna (100) according to one of the preceding claims, wherein said at least one electromechanic actuator (120) comprises an electroactive Polymer material.

4. Antenna (100) according to one of the preceding claims, wherein said at least one electromechanic actuator (120) is arranged on a carrier element (102) of said Antenna (100), wherein preferably a first surface (120a) of said electromechanic actuator (120) is arranged on a surface (102a) of said carrier element (102).

5. Antenna (100) according to claim 4, wherein at least one antenna element (110) is arranged on a second surface (120b) of said at least one electromechanic actuator (120), wherein said second surface (120b) is preferably arranged opposite to said first surface (102a) of said at least one electromechanic actuator (120), preferably along a direction of movement.

6. Antenna (100) according to one of the preceding claims, wherein an electrically isolating element, preferably an electrically isolating layer (126), is interposed between said at least one antenna element (110) and said at least one electromechanic actuator (120) or a component (124b) thereof.

7. Antenna (100) according to one of the preceding claims, wherein at least one antenna element (110) comprises a flexible waveguide (112) connected to said antenna element (110).

8. Antenna (100) according to one of the preceding claims, wherein said at least one electromechanic actuator (120) comprises a basically cylindrical geometry, particularly with a rectangular cross-section.

9. Antenna (100) according to claim 8, wherein said at least one electromechanic actuator (120) is arranged on a surface (102a) of a carrier element (102) of said Antenna (100) such that a longitudinal axis (LA) of said at least one electromechanic actuator (120) extends substantially parallel to said surface (102a) of said carrier element (102).

10. Antenna (100) according to claim 9, wherein a plurality of antenna elements (110_1, 110_2, 110_3) is arranged along said longitudinal axis (LA) of said at least one electromechanic actuator (120).

11. Antenna (100) according to one of the preceding claims, wherein two or more electromechanic actuators (1200, 1202, 1204) are provided.

12. Antenna (100) according to claim 11, wherein at least one antenna element, preferably more than two antenna elements (110_9, 110_10, 110_11), are provided on each electromechanic actuator (1206).

13. Antenna (100) according to one of the claims 11 to 12, wherein at least two electromechanic actuators (1206, 1208) comprise different geometry and/or size.

14. Method of operating an antenna (100) comprising at least one antenna element (110) for transmitting and/or receiving radio frequency, RF, signals, wherein said antenna (100) comprises at least one electromechanic actuator (120), and wherein said at least one antenna element (110) is moved with respect to a further component (102, 110') of said Antenna (100) by means of said at least one electromechanic actuator (120).

15. Method according to claim 14, wherein a relative phase between RF signals transmitted from and/or received from two different antenna elements (110, 110') is controlled by moving at least one of said two different antenna elements (110, 110') by means of said at least one electromechanic actuator (120), preferably by applying a control voltage to said at least one electromechanic actuator (120).

## Amended claims

### Amended claims in accordance with Rule 137(2) EPC.

1. Antenna (100) comprising at least one antenna element (110) for transmitting and/or receiving radio frequency, RF, signals, wherein said antenna (100) comprises at least one electromechanic actuator (120) for moving said at least one antenna element (110) with respect to a further component (102, 110') of said antenna (100), wherein said at least one electromechanic actuator (120) comprises an electroactive Polymer material, wherein said antenna (100) is configured to move said at least one antenna element (110) by means of said electromechanic actuator (120) independently from further antenna elements (110').

2. Antenna (100) according to claim 1, wherein said at least one electromechanic actuator (120) is configured to move said at least one antenna element (110) with respect to at least one further antenna element (110') of said Antenna (100).

3. Antenna (100) according to one of the preceding claims, wherein said at least one electromechanic actuator (120) is arranged on a carrier element (102) of said Antenna (100), wherein preferably a first surface (120a) of said electromechanic actuator (120) is arranged on a surface (102a) of said carrier element (102).

4. Antenna (100) according to claim 3, wherein at least one antenna element (110) is arranged on a second surface (120b) of said at least one electromechanic actuator (120), wherein said second surface (120b) is preferably arranged opposite to said first surface (102a) of said at least one electromechanic actuator (120), preferably along a direction of movement.

5. Antenna (100) according to one of the preceding claims, wherein an electrically isolating element, preferably an electrically isolating layer (126), is interposed between said at least one antenna element (110) and said at least one electromechanic actuator (120) or a component (124b) thereof.

6. Antenna (100) according to one of the preceding claims, wherein at least one antenna element (110) comprises a flexible waveguide (112) connected to said antenna element (110).

7. Antenna (100) according to one of the preceding claims, wherein said at least one electromechanic actuator (120) comprises a basically cylindrical geometry, particularly with a rectangular cross-section.

8. Antenna (100) according to claim 7, wherein said at least one electromechanic actuator (120) is arranged on a surface (102a) of a carrier element (102) of said Antenna (100) such that a longitudinal axis (LA) of said at least one electromechanic actuator (120) extends substantially parallel to said surface (102a) of said carrier element (102).

9. Antenna (100) according to claim 8, wherein a plurality of antenna elements (110_1, 110_2, 110_3) is arranged along said longitudinal axis (LA) of said at least one electromechanic actuator (120).

10. Antenna (100) according to one of the preceding claims, wherein two or more electromechanic actuators (1200, 1202, 1204) are provided.

11. Antenna (100) according to claim 10, wherein at least one antenna element, preferably more than two antenna elements (110_9, 110_10, 110_11), are provided on each electromechanic actuator (1206).

12. Antenna (100) according to one of the claims 10 to 11, wherein at least two electromechanic actuators (1206, 1208) comprise different geometry and/or size.

13. Method of operating an antenna (100) comprising at least one antenna element (110) for transmitting and/or receiving radio frequency, RF, signals, wherein said antenna (100) comprises at least one electromechanic actuator (120), and wherein said at least one antenna element (110) is moved with respect to a further component (102, 110') of said antenna (100) by means of said at least one electromechanic actuator (120), wherein said at least one electromechanic actuator (120) comprises an electroactive Polymer material, wherein said antenna (100) moves said at least one antenna element (110) by means of said electromechanic actuator (120) independently from further antenna elements (110').

14. Method according to claim 13, wherein a relative phase between RF signals transmitted from and/or received from two different antenna elements (110, 110') is controlled by moving at least one of said two different antenna elements (110, 110') by means of said at least one electromechanic actuator (120), preferably by applying a control voltage to said at least one electromechanic actuator (120).
